# EUROPEAN PATENT APPLICATION

(11) **EP 1 801 900 A2**
(43) Date of publication of application: **27.06.2007**
(21) Application number: 06126329.9
(22) Date of filing: 18.12.2006
(51) Int. Cl.: H01L 51/52

(54) **Organic light emitting diode, manufacturing method thereof, and organic light emitting diode display provided with the same**

(30) Priority: 23.12.2005 KR 20050128466
(71) Applicant: Samsung Electronics Co., Ltd., Suwon-si, Gyeonggi-Do (KR)
(72) Inventor: OH, Joon-Hak 302-1801 Dodammaeul, Jukjeon-dong Yongin-si Gyeonggi-do (KR)
(74) Representative: Modiano, Micaela Nadia

(57) **Abstract**

The present invention relates to an OLED, and to a method of manufacturing the OLED, as well as to an OLED display having the OLED, which includes a first electrode, a second electrode facing the first electrode and a light emitting member interposed between the first electrode and the second electrode, wherein the first electrode, the second electrode and the light emitting member form a linear light emitter having a coaxial structure.

## Description

This application claims priority to Korean Patent Application No. 10-2005-0128466, filed on December 23, 2005, and the contents of which in its entirety are herein incorporated by reference.

### BACKGROUND OF THE INVENTION

### (a) Field of the Invention

The present invention relates to an organic light emitting diode, to a method of manufacturing the organic light emitting diode, and to an organic light emitting diode display having the organic light emitting diode.

### (b) Description of the Related Art

Recently, it has been desired to reduce the weight and thickness of monitors and television sets. Accordingly, liquid crystal displays ("LCDs") are being substituted for the heavier and thicker cathode ray tubes ("CRT") displays.

However, an LCD needs to have a separate backlight as a light receiving and emitting element and has problems associated with response speed and viewing angle.

In recent years, an organic light emitting diode ("OLED") display has attracted attention as a display device capable of overcoming the above problems.

The OLED display includes an organic light emitting diode including two electrodes having a light emitting layer interposed between the two electrodes. In the organic light emitting diode, electrons injected from one of the two electrodes and holes injected from the other electrode are recombined in the light emitting layer to form excitons. The excitons release energy in the form of emitting light.

The OLED display is a self-emitting display device, and thus does not need a separate light source. Therefore, the OLED display is advantageous in response speed, viewing angle and contrast ratio, as well as in power consumption.

The OLED display includes a plurality of pixels. Each pixel being minutely formed in order to obtain high resolution.

However, since the pixels are usually patterned by, for example, a photolithography method, there is a limit to reducing the size of a pixel.

### BRIEF SUMMARY OF THE INVENTION

The present invention has been made in an effort to provide a technology for forming nano-sized pixels in order to realize high resolution and to overcome the above-mentioned problems.

According to an exemplary embodiment of the present invention, an OLED includes a first electrode, a second electrode facing the first electrode and a light emitting member interposed between the first electrode and the second electrode. The first electrode, the second electrode and the light emitting member form a linear light emitter having a coaxial structure.

The first electrode, the second electrode and light emitting member interposed therebetween may be concentric.

The linear light emitter may have a diameter equal to or smaller than about 200 nm.

The linear light emitter may include a core including the second electrode, a first shell surrounding the core and including the light emitting member, and a second shell surrounding the first shell and including the first electrode.

Alternatively, the linear light emitter may include a first shell formed to have a hollow therein and including the second electrode, a second shell surrounding the first shell and including the light emitting member, and a third shell surrounding the second shell and including the first electrode.

The light emitting member may include a light emitting layer including an organic semiconductor, and at least one of a first auxiliary layer interposed between the light emitting layer and the first electrode and a second auxiliary layer interposed between the light emitting layer and the second electrode.

At least one of the first electrode and the second electrode may contain a transparent material.

The linear light emitter may be a nanowire or a nanotube.

According to another exemplary embodiment of the present invention, there is provided a method of manufacturing an OLED. The method includes: preparing a template having a first pore therein; forming in the first pore a first tube-shaped electrode having a second pore whose diameter is smaller than that of the first pore; forming in the second pore a tube-shaped light emitting member having a third pore whose diameter is smaller than that of the second pore; and forming a second electrode in the third pore.

In the forming of the light emitting member, at least one layer may be formed.

The second electrode may be formed in a tube shape or a rod shape.

At least one of the forming of the first electrode, the forming of the light emitting member and the forming of the second electrode may be performed by a vapor phase method.

The vapor phase method may include vapor deposition.

The vapor phase method may include vapor polymerization.

The vapor polymerization method may include supplying gaseous monomers into at least one of the first to third pores and polymerizing the monomers.

The polymerizing of the monomers may be performed in a vacuum atmosphere.

The polymerizing of the monomers may be performed at a temperature of about 50° C to about 200° C.

The method of manufacturing an OLED may further include introducing a polymerization initiator into at least one of the first to third pores before the supplying of the monomers.

The polymerization initiator may contain at least one of 2,2'-azobisisobutyronitrile ("AIBN"), benzoyl peroxide ("BPO"), cerium ammonium nitride ("CAN"), and ferric chloride ("FeCl₃").

The method of manufacturing an OLED may further include separating the OLED from the template after the polymerizing of the monomers.

The template may be comprise aluminum oxide, and the separating of the OLED may be performed by etching the template.

At least one of sodium hydroxide and hydrochloric acid may be used for the etching.

According to still another exemplary embodiment of the present invention, an OLED display includes a substrate and linear light emitters formed on the substrate. Each linear light emitter includes a first electrode, a second electrode and a light emitting member interposed between the first electrode and the second electrode. The first electrode, the second electrode and the light emitting member form a coaxial structure.

The OLED display may further include the first electrode, the second electrode and light emitting member interposed therebetween being concentric.

The linear light emitter may be a nanowire or a nanotube.

The OLED display may further include a thin film transistor ("TFT") connected to the linear light emitter.

According to yet still another exemplary embodiment of the present invention, an OLED display includes: a substrate; a first signal line formed on the substrate; a second signal line intersecting the first signal line; a first TFT connected to the first and second signal lines; a second TFT connected to the first TFT; and a linear light emitter connected to the second TFT. Each linear light emitter includes: a first electrode connected to the second TFT; a second electrode facing the first electrode; and a light emitting member interposed between the first electrode and the second electrode. The first electrode, the light emitting member and the second electrode form a coaxial structure.

The first electrode, the second electrode and light emitting member interposed therebetween may be concentric.

The linear light emitter may have a diameter equal to or smaller than about 200 nm.

The linear light emitter may be a nanotube or a nanowire.

### BRIEF DESCRIPTION OF THE DRAWINGS

The above and/or other aspects, features and advantages of the present invention will become apparent and more readily appreciated from the following description of the exemplary embodiments, taken in conjunction with the accompanying drawings of which:
FIG. 1 is a perspective view schematically illustrating an OLED according to an exemplary embodiment of the present invention;
FIGS. 2A to 2Gare perspective schematic diagrams sequentially illustrating a method of manufacturing an OLED according to an exemplary embodiment of the present invention;
FIG. 3 is an equivalent circuit schematic diagram of an OLED display according to an exemplary embodiment of the present invention;
FIG. 4 is a plan view illustrating a layout of an OLED display according to an exemplary embodiment of the present invention;
FIG. 5 is a cross-sectional view of the OLED display shown in FIG. 4 taken along line V-V of FIG. 4; and
FIGS. 6A and 6B are enlarged partial perspective views illustrating a portion 'A' of the OLED display shown in FIG. 5.

### DETAILED DESCRIPTION OF THE INVENTION

The present invention will now be described more fully hereinafter with reference to the accompanying drawings, in which exemplary embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another elements as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper," depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments of the present invention are described herein with reference to cross section illustrations that are schematic illustrations of idealized embodiments of the present invention. As such, variations from the shapes of the illustrations as a result, for example, of manufacturing techniques and/or tolerances, are to be expected. Thus, embodiments of the present invention should not be construed as limited to the particular shapes of regions illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present invention.

Hereinafter, the present invention will be described in more detail with reference to the accompanying drawings.

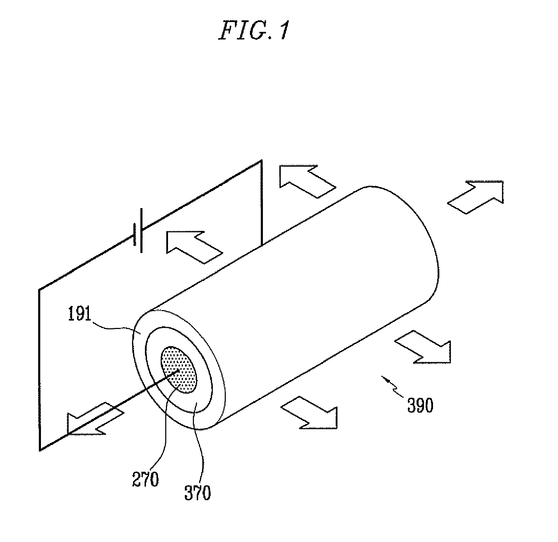

Now, an OLED according to an exemplary embodiment of the present invention will be described in more detail with specific reference to FIG. 1.

FIG.1 is a perspective view schematically illustrating an OLED according to an exemplary embodiment of the present invention.

The OLED according to the present exemplary embodiment of the present invention is a linear light emitter having a diameter of about 200 nanometers (nm) or less and a length of several tens of micrometers (mm) to several hundreds of micrometers (mm).

Hereinafter, the OLED according to exemplary embodiments of the present invention is referred to as a "linear light emitter".

Referring to FIG. 1, a linear light emitter 390 according to an exemplary embodiment of the present invention includes a common electrode 270 and a pixel electrode 191 to which voltages are applied, and an organic light emitting member 370 interposed therebetween.

The common electrode 270 may be made of a metallic material having a low work function, such as Cs, Li, Ca, or Ba, or Al, Cu, Ag, or an alloy comprising at least one of the foregoing metals.

The pixel electrode 191 may be made of a material having conductivity and transmittance to emit light to the outside, such as indium tin oxide ("ITO") or indium zinc oxide ("IZO").

The organic light emitting member 370 may have a multi-layered structure including a light emitting layer (not shown) and at least one auxiliary layer (not shown) for improving the light emitting efficiency of the light emitting layer.

The light emitting layer may be made of an organic material which uniquely emits light of one of three primary colors, such as red, green, and blue, for example, or a mixture of an organic material and an inorganic material, and contains a low-molecular-weight material and a high-molecular-weight material.

Examples of the low-molecular-weight material include a metal complex compound, such as tris-(8-hydroxyquinoline)aluminum ("Alq3") or bis(benzoquinoline)beryllium ("BeBq2"), or an organic material, such as rhodamine-B, fluorescein, pyrene, 4,4'-bis(2,2'-diphenylethen-1-yl)-diphenyl ("DPVBi"), pentacene, or rubrence. About 1% to 5% of a dopant may be added to the low-molecular-weight material, resulting in high light emitting efficiency.

Examples of the high-molecular-weight material include a polyfluorene derivative, a (poly)paraphenylenevinylene derivative, a polyphenylene derivative, a polyvinylcarbazole, and a polythiophene derivative, or compounds obtained by doping these high-molecular-weight materials with perylene dye, coumarin dye, rhodarmine dye, rubrene, perylene, 9,10-diphenylanthracene, tetraphenylbutadiene, Nile red, coumarin, quinacridone, etc.

Electrons and holes injected from both the electrodes 191 and 270 are recombined with each other in the light emitting layer such that the light emitting layer becomes an excited state. When the light emitting layer returns to a ground state, the light emitting layer releases energy, that is, emits light.

Examples of the auxiliary layer include an electron transport layer (not shown) and a hole transport layer (not shown) which achieve the balance of electrons and holes, and an electron injection layer (not shown) and a hole injection layer (not shown) which reinforce the injection of the electrons and the holes. The organic light emitting member 370 may include at least one of these auxiliary layers. Each of the hole transport layer and the hole injection layer may be made of a material having a highest occupied molecular orbital ("HOMO") level between the work function of the pixel electrode 191 and the HOMO level of the light emitting layer. Each of the electron transport layer and the electron injection layer may be made of a material having a lowest unoccupied molecular orbital ("LUMO") level between the work function of the common electrode 270 and the LUMO level of the light emitting layer. For example, the hole transport layer or the hole injection layer may be made of a mixture of poly-(3,4-ethylenedioxythiophene) and polystyrenesulfonate ("PEDOT:PSS").

The linear light emitter 390 shown in FIG. 1 includes the pixel electrode 191, the organic light emitting member 370 and the common electrode 270, which are sequentially formed from the outside to the inside, as illustrated. However, the common electrode 270, the organic light emitting member 370 and the pixel electrode 191 may be sequentially formed from the outside to the inside. In either case, a coaxial structure is formed in which the pixel electrode 191, the organic light emitting member 370 and the common electrode 270 are concentric.

In the former case, the pixel electrode 191 serves as an anode and the common electrode 270 serves as a cathode. In the latter case, the pixel electrode 191 serves as a cathode and the common electrode 270 serves as an anode.

The linear light emitter 390 shown in FIG. 1 is a nanowire. The nanowire 390 includes an unhollowed core having a rod shape and at least one shell surrounding the core. The nanowire may include a core serving as the common electrode 270, an outermost shell serving as the pixel electrode 191, and a plurality of shells that are interposed between the core and the outermost shell serving as the organic light emitting member 370.

Although not shown in FIG. 1, the linear light emitter 390 may be a nanotube. The nanotube includes at least one shell formed to surround a hollow inside. The nanotube may include an innermost shell and an outermost shell serving as electrodes and a plurality of shells interposed between the innermost shell and the outermost shell serving as the organic light emitting member.

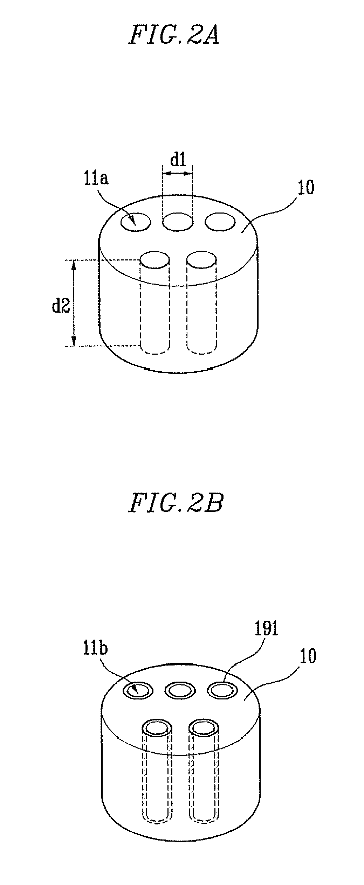

Referring now to FIGS. 2A to 2G, a method of manufacturing an OLED according to an exemplary embodiment of the present invention will be described in more detail hereinbelow.

FIGS. 2A to 2G are perspective schematic diagrams sequentially illustrating a method of manufacturing a linear light emitter according to an exemplary embodiment of the present invention.

As shown in FIG. 2A, a template 10 having a plurality of pores 11a therein is prepared. A diameter d1 of the pores 11a may be smaller than about 200 nm and a thickness d2 of the pores 11a may be in a range of about several tens of micrometers to several hundreds of micrometers. The template 10 may be made of aluminum oxide, for example, but is not limited thereto.

Next, as shown in FIG. 2B, the pixel electrodes 191 are formed of a transparent material, such as ITO or IZO, by a vapor deposition. The vapor deposition may be, for example, a sputtering or a thermal evaporation. The thermal evaporation method is preferable since it can reduce the damage to an outer film. Since the pixel electrodes 191 are formed along the sidewalls defining the pores 11a, they have a tube shape. Pores 11b having a diameter smaller than that of the pores 11a are formed in the pixel electrodes 191.

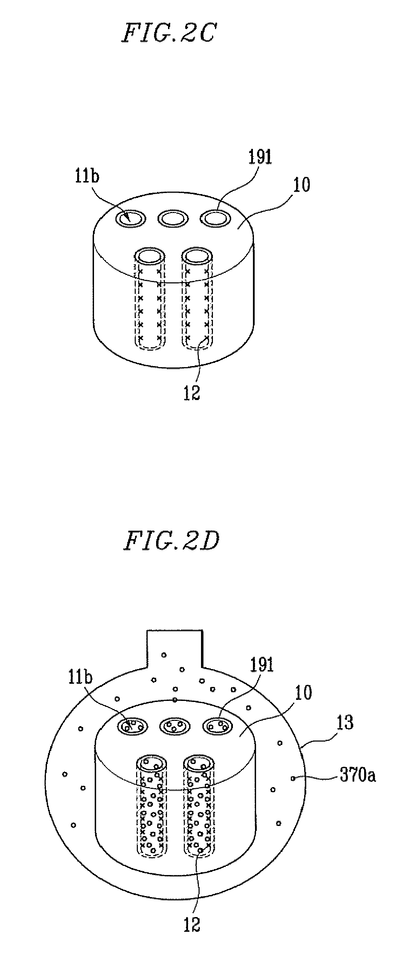

Next, as shown in FIG. 2C, an initiator 12 is introduced into the pores 11b. The initiator 12 initiates radical polymerization or redox polymerization. In the radical polymerization, the initiator 12 may be 2,2'-azobisisobutyronitrile ("AIBN"), benzoyl peroxide ("BPO"), or cerium ammonium nitride ("CAN"). In the redox polymerization, the initiator 12 may be ferric chloride ("FeCl₃") or hydrogen peroxide.

The initiator 12 may be introduced into the pores 11b by soaking the template 10 in an initiator solution and performing a drying process or by a vapor phase method.

Next, as shown in FIG. 2D, the template 10 is positioned in a vacuum chamber 13 (shown schematically). It is preferable that a vacuum pressure be lower than about 10⁻² Torr.

Subsequently, gaseous monomers 370a are supplied in the vacuum chamber 13. When the monomers 370a are liquid or solid at room temperature, the liquid or solid is evaporated or sublimated by heating and/or under vacuum. The monomers 370a may be pyrrole, aniline, thiophene, etc.

Then, as shown in FIG. 2E, the monomers 370a are polymerized to form a polymer, and the organic light emitting members 370 are formed of the polymer. Since the organic light emitting members 370 are formed along the sidewalls of the pores 11b, they have a tube shape. Pores 11c having a diameter smaller than that of the pores 11b are formed in the organic light emitting members 370.

The polymerization is performed by heating the template 10 at a temperature of about 50° C to 200° C depending on the kind of monomers 370a. The polymer may be polypyrrole, polyaniline, or polythiophene, depending on the kind of monomers 370a.

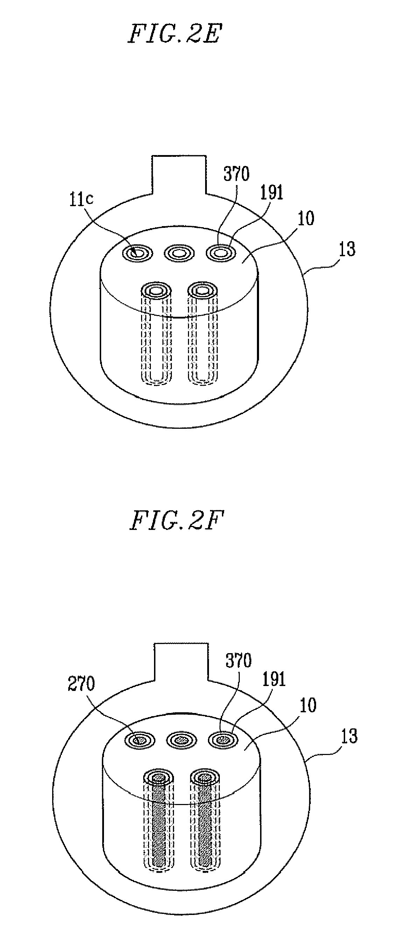

Subsequently, as shown in FIG. 2F, the common electrodes 270 are formed of a conductive material by a vapor deposition. The vapor deposition may be, for example, the sputtering or the thermal deposition. Since the common electrodes 270 are formed along the sidewalls of the pores 11c, they have a hollowed tube shape or alternatively have an unhollowed rod shape completely filling the pores 11c.

According to the above-mentioned method, linear light emitters 390 including the two electrodes 191 and 270 and the organic light emitting member 370 interposed between the two electrodes 191 and 270 are formed.

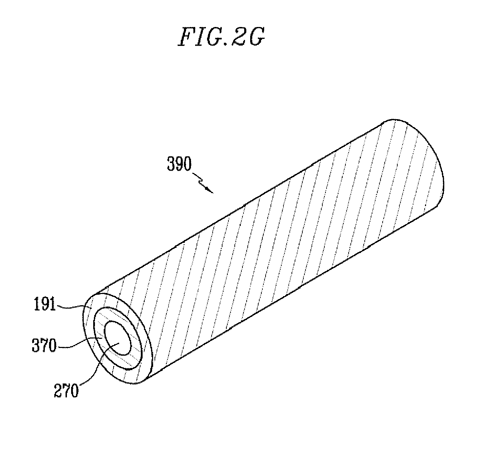

Then, as shown in FIG. 2G, the linear light emitters 390 are separated from the template 10. When the template 10 is made of aluminum oxide, it can be removed by etching with hydrochloric acid or sodium hydroxide. If necessary, the template 10 having the linear light emitters 390 formed inside the pores 11a may be used without the separating process.

In the above-mentioned exemplary embodiment, the organic light emitting members 370 contain a high-molecular-weight material made by the vapor polymerization. However, when the organic light emitting members 370 contain a low-roolecular-weight material, they may be formed by a vapor deposition, such as the thermal deposition.

Further, in the above-mentioned exemplary embodiment, the organic light emitting member 370 has a single-layered structure. However, the organic light emitting member 370 may include at least one of the above-mentioned auxiliary layers. In this case, the at least one auxiliary layer may be formed after the pixel electrodes 191 are formed or before the common electrodes 270 are formed.

As described above, when the linear light emitters 390 are formed by a vapor phase method, such as by vapor polymerization or vapor deposition, a separate solvent is unnecessary and thus a solvent recovering process after completing the linear light emitters 390 is unnecessary, unlike with a liquid phase method. Further, it is easy to adjust the thickness of each layer according to the polymerization or deposition conditions. Furthermore, the linear light emitters 390 can be formed to have a multi-layered structure with uniform surfaces and interfaces.

Hereinafter, an active matrix OLED ("AMOLED") display including a plurality of linear light emitters 390 according to an exemplary embodiment of the present invention will be described. A description of the same parts as those in the above-mentioned exemplary embodiment will be omitted for sake of brevity.

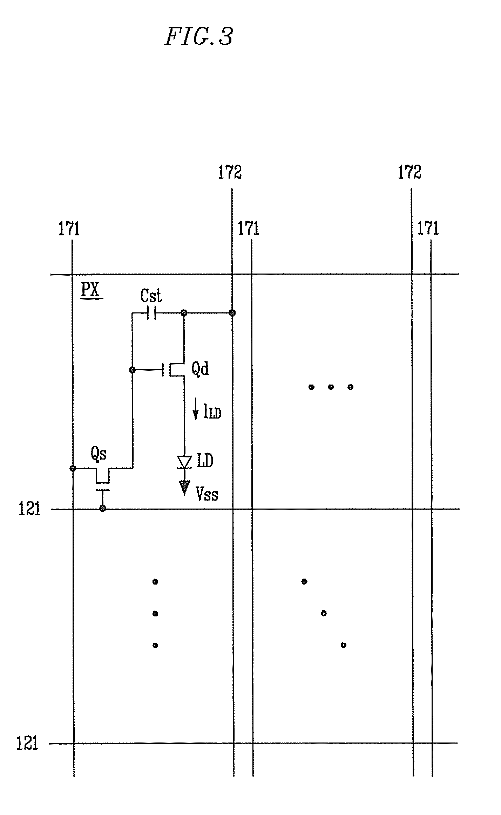

First, an AMOLED display according to an exemplary embodiment of the present invention will be described in more detail with reference to FIG. 3.

FIG. 3 is an equivalent circuit schematic diagram of the AMOLED display according to the exemplary embodiment of the present invention.

Referring to FIG. 3, the AMOLED display according to the present exemplary embodiment includes a plurality of signal lines 121, 171 and 172 and a plurality of pixels PX connected to the plurality of signal lines and are arranged substantially in a matrix.

The plurality of signal lines include a plurality of gate lines 121 for transmitting gate signals (or scanning signals), a plurality of data lines 171 for transmitting data signals, and a plurality of driving voltage lines 172 for transmitting driving voltages. The gate lines 121 extend substantially in parallel with one another in a row direction, and the data lines 171 and the driving voltage lines 172 extend substantially in parallel with one another in a column direction.

Each pixel PX includes a switching transistor Qs, a driving transistor Qd, a storage capacitor Cst and an OLED LD.

The switching transistor Qs has a control terminal, an input terminal and an output terminal. In the switching transistor Qs, the control terminal is connected to the gate line 121, the input terminal is connected to the data line 171, and the output terminal is connected to the driving transistor Qd. The switching transistor Qs transmits the data signal supplied to the data line 171 to the driving transistor Qd in response to the scanning signal supplied to the gate line 121.

The driving transistor Qd has a control terminal, an input terminal and an output terminal, In the driving transistor Qd, the control terminal is connected to the switching transistor Qs, the input terminal is connected to the driving voltage line 172, and the output terminal is connected to the OLED LD. In the driving transistor Qd, an output current I_{LD}, of which the magnitude varies according to the voltage between the control terminal and the output terminal, flows.

The capacitor Cst is connected between the control terminal and the input terminal of the driving transistor Qd. The capacitor Cst is charged on the basis of the data signal supplied to the control terminal of the driving transistor Qd and maintains the charged state after the switching transistor Qs is turned off.

The OLED LD has an anode connected to the output terminal of the driving transistor Qd and a cathode connected to a common voltage Vss. The OLED LD emits light of which the intensity varies depending on the output current I_{LD} of the driving transistor Qd to display an image.

Each of the switching transistor Qs and the driving transistor Qd is an n-channel field effect transistor ("FET"). However, at least one of the switching transistor Qs and the driving transistor Qd may be a p-channel FET. The connection relationship among the switching transistor Qs, the driving transistor Qd, the storage capacitor Cst and the OLED LD may be changed.

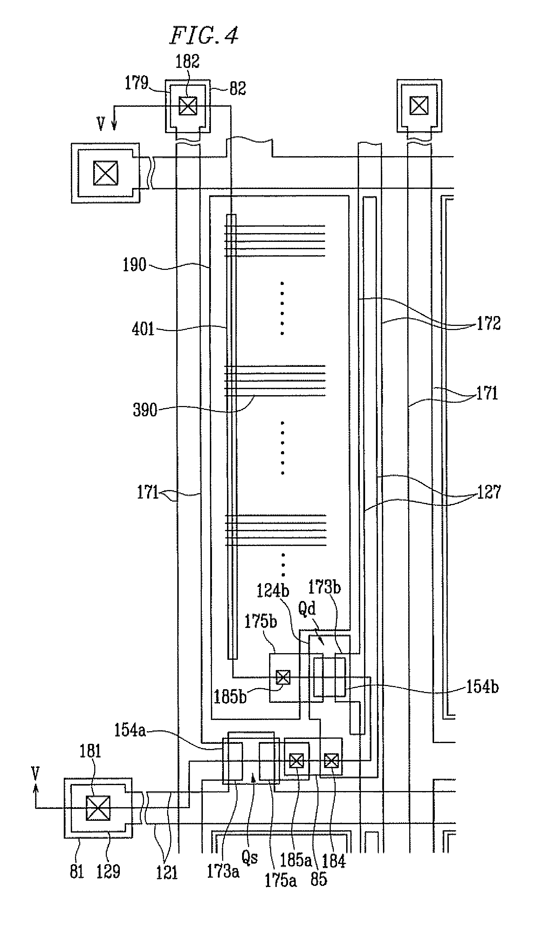

Now, the structure of the AMOLED display shown in FIG. 3 will be described in more detail with reference to FIGS. 4 to 6B, as well as FIG. 3.

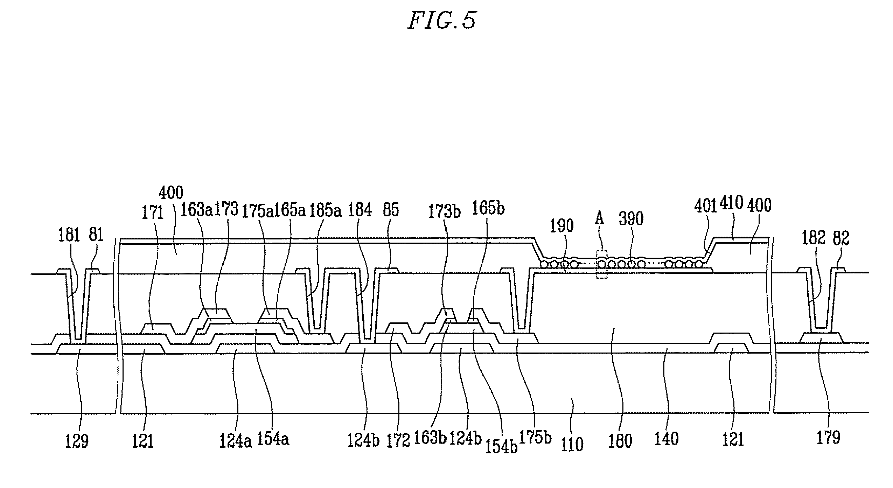

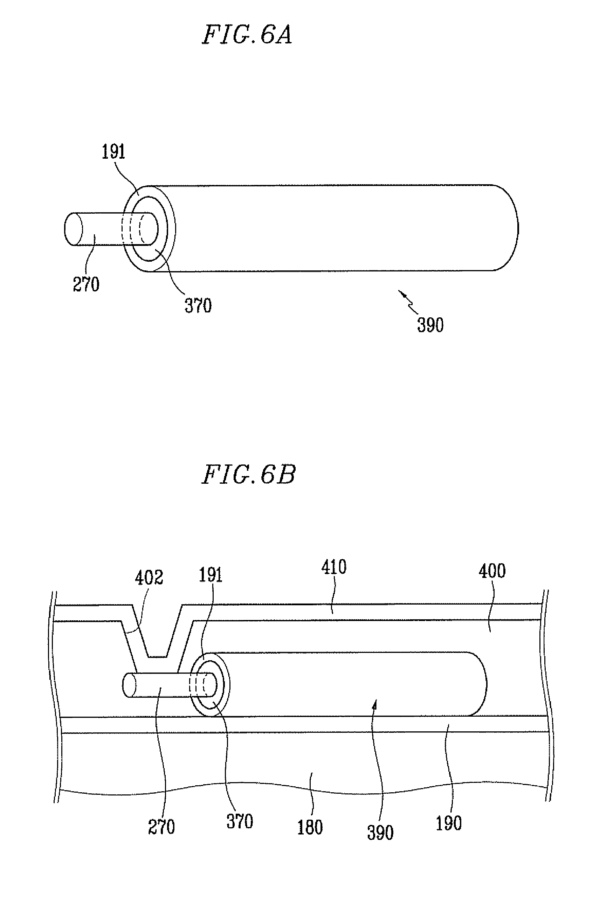

FIG. 4 is a plan view illustrating the layout of an AMOLED display according to an exemplary embodiment of the present invention. FIG. 5 is a cross-sectional view of the AMOLED display shown in FIG. 4 taken along line V-V in FIG. 4. FIGS. 6A and 6B are enlarged partial perspective views illustrating a portion 'A' of the AMOLED display shown in FIG. 5.

A plurality of gate conductors including a plurality of gate lines 121 and a plurality of second control electrodes 124b are formed on an insulating substrate 110 made of transparent glass or plastic.

The gate lines 121 transmit the gate signals and extend substantially in a horizontal direction, as illustrated in FIG. 4. Each of the gate lines 121 includes a plurality of first control electrodes 124a extending upward and a wide end portion 129 for connection to another layer or an external driving circuit (not shown). When a gate driving circuit (not shown) which generates the gate signals is integrated on the substrate 110, the gate lines 121 may extend to be directly connected to the gate driving circuit.

The second control electrodes 124b are separated from the gate lines 121, and have a storage electrode 127 that extends downward, extends to the right for a short distance, and then extends upward for a longer distance, as illustrated in FIG. 4.

The gate conductors 121 and 124b may be made of an Al-containing metal, such as Al or an Al alloy, an Ag-contairung metal, such as Ag or an Ag alloy, a Cu-containing metal, such as Cu or a Cu alloy, a Mo-containing metal, such as Mo or a Mo alloy, Cr, Ta, Ti, etc. However, the gate conductors 121 and 124b may have a multi-layered structure with two conductive films (not shown) having different physical properties.

The side surfaces of the gate conductors 121 and 124b are inclined with respect to a surface of the substrate 110, and the inclination angle is desirably within a range of about 30° to about 80°.

A gate insulating layer 140 is formed of, for example, silicon nitride ("SiNₓ") or silicon oxide ("SiOₓ"), on the gate conductors 121 and 124b.

On the gate insulating layer 140, a plurality of first semiconductors 154a and a plurality of second semiconductors 154b are formed of, for example, hydrogenated amorphous silicon (amorphous silicon will be abbreviated to "a-Si") or polysilicon. The first semiconductor 154a and the second semiconductor 154b have an island shape, as illustrated in FIG. 4. The first semiconductors 154a are positioned on the first control electrodes 124a, and the second semiconductors 154b are positioned on the second control electrodes 124b.

A plurality of pairs of first ohmic contacts 163a and 165a and a plurality of pairs of second ohmic contacts 163b and 165b are formed on the first and second semiconductors 154a and 154b, respectively. Each of the first and second ohmic contacts 163a, 163b, 165a and 165b has an island shape. The first and second ohmic contacts 163a, 163b, 165a and 165b may be made of, for example, silicide or n+ hydrogenated a-Si highly doped with n-type impurity.

On the first and second ohmic contacts 163a, 163b, 165a and 165b and the gate insulating layer 140, a plurality of data conductors are formed. The plurality of data conductors include a plurality of data lines 171, a plurality of driving voltage lines 172, a plurality of first output electrodes 175a and a plurality of second output electrodes 175b.

The data lines 171 transmit data signals and substantially extend in a vertical direction so as to intersect the gate lines 121, as illustrated in FIG. 4. Each of the gate lines 171 includes first input electrodes 173a extending toward the first control electrode 124a, and a wide end portion 179 for connecting to another layer or an external driving circuit (not shown). When a data driving circuit (not shown) which generates the data signals is integrated on the substrate 110, the data lines 171 may extend to be directly connected to the data driving circuit.

The driving voltage lines 172 transmit the driving voltages and extend substantially in the vertical direction so as to intersect the gate lines 121, as illustrate din FIG. 4. Each of the driving voltage lines 172 includes a plurality of second input electrodes 173b extending toward the second control electrodes 124b. The driving voltage lines 172 overlap the storage electrodes 127.

The first and second output electrodes 175a and 175b are separated from each other, and are also separated from the data lines 171 and the driving voltage lines 172. The first input electrode 173a and the first output electrode 175a face each other on the first semiconductor 154a, and the second input electrode 173b and the second output electrode 175b face each other on the second semiconductor 154b.

The plurality of data conductors including the plurality of data lines 171, the plurality of driving voltage lines 172, the plurality of first output electrodes 175a and the plurality of second output electrodes 175b are preferably made of a refractory metal, such as Mo, Cr, Ta, and Ti, or an alloy thereof. Further, each of the data conductors may have a multi-layered structure including a refractory metal film (not shown) and a low-resistance conductive layer (not shown).

Similar to the gate conductors 121 and 124b, the side surfaces of the data conductors 171, 172, 175a and 175b are desirably inclined at an angle of about 30° to about 80° with respect to the surface of the substrate 110.

A passivation layer 180 is formed on the data conductors 171, 172, 175a and 175b exposing portions of the first and second semiconductors 154a and 154b, and the gate insulating layer 140.

The passivation layer 180 may be made of an inorganic insulator or an organic insulator to have a flat surface. Examples of the inorganic insulator include silicon nitride ("SiNₓ") and silicon oxide ("SiOₓ"), and examples of the organic insulator include polyacryl compounds. The passivation layer 180 may have a double-layered structure of an inorganic film and an organic film.

In the passivation layer 180, a plurality of contact holes 182, 185a and 185b are formed so as to expose the end portions 179 of the data lines 171 and the first and second output electrodes 175a and 175b, respectively. Further, a plurality of contact holes 181 and 184 are formed in the passivation layer 180 and the gate insulating layer 140 so as to expose the end portions 129 of the gate lines 121 and the second input electrodes 124b, respectively.

A plurality of lower conductors 190, a plurality of connecting members 85 and a plurality of contact assistants 81 and 82 are formed on the passivation layer 180.

The lower conductors 190 are physically and electrically connected to the second output electrodes 175b through the contact holes 185b.

The connecting member 85 is connected to the second control electrode 124b and the first output electrode 175a through the contact holes 184 and 185a.

The contact assistants 81 and 82 are connected to the end portions 129 of the gate lines 121 and the end portions 179 of the data lines 171 through the contact holes 181 and 182, respectively. The contact assistants 81 and 82 assist adhesion between the end portions 129 and 179 of the gate lines 121 and the data lines 171 and an external device (not shown) and also protect the end portions 129 and 179.

An insulating layer 400 is formed on the passivation layer 180, the lower conductors 190 and the connecting members 85. The insulating layer 400 has openings 401 exposing the lower conductors 190. The insulating layer 400 may be made of an organic insulator having heat resistance and solvent resistance, such as acrylic resin or polyimide resin, or an inorganic insulator, such as SiOx or TiO₂ Alternatively, the insulating layer 400 may include at least two layers. Also, the insulating layer 400 may be made of a photosensitive material containing black pigment. In this case, the insulating layer 400 serves as a light blocking member and can be formed by a simple process.

A plurality of linear light emitters 390 are formed in each opening 401. One linear light emitter 390 may define a light emitting region of one pixel, a bundle of linear light emitters 390 may define a light emitting region of one pixel, or a plurality of linear light emitters 390 may define a light emitting region of one pixel. In FIG. 5, the plurality of linear light emitters 390 are arranged in parallel with one another. However, the plurality of linear light emitters 390 may be disorderly arranged.

Similar to the above-mentioned exemplary embodiment, each linear light emitter 390 includes the common electrode 270, the pixel electrode 191 and the organic light emitting member 370 interposed between the common electrode 270 and the pixel electrode 191, which form a coaxial structure, as shown in FIG. 6A.

The pixel electrode 191 may be made of a material having a light transmitting property and conductivity, for example, ITO or IZO.

The organic light emitting member 370 may have a multi-layered structure including a light emitting layer (not shown) and at least one auxiliary layer (not shown) for improving the light emitting efficiency of the light emitting layer.

The common electrode 270 may be made of a metallic material having a low work function, such as Cs, Li, Ca, or Ba, or Al, Cu, Ag, or an alloy of at least one of the foregoing metals. As shown in FIG. 6A, the common electrode 270 may be formed having a protruding end portion to facilitate connection to a common electrode (not shown) of another pixel (not shown).

A pair of the common electrode 270 and the pixel electrode 191 causes a current to pass through the organic light emitting member 370.

As best seen in FIG. 6B, an upper conductor 410 is formed on the linear light emitter 390 and the insulating layer 400. A common voltage is applied to the upper conductor 410. The upper conductor 410 transmits the applied common voltage to the common electrode 270 through a contact hole 402.

The pixel electrode 191 of the linear light emitter 390 is insulated from the upper conductor 410 by the insulating layer 400.

Meanwhile, as shown in FIGS. 5, 6A and 6B, the pixel electrode 191 of the linear light emitter 390 is physically and electrically connected to the second output electrode 175b through the lower conductor 190. The common electrode 270 of the linear light emitter 390 is connected to the upper conductor 410 through the protruding portion such that the common voltage from the upper conductor 410 is applied to the common electrode 270.

In the OLED display illustrated in FIGS. 4 and 5, a first control electrode 124a connected to a gate line 121, a first input electrode 173a connected to a data line 171, and a first output electrode 175a form a switching TFT Qs together with a first semiconductor 154a. A channel of the switching TFT Qs is formed in the first semiconductor 154a between the first input electrode 173a and the first output electrode 175a. A second control electrode 124b connected to a first output electrode 175a, a second input electrode 173b connected to a driving voltage line 172, and a second output electrode 175b connected to a pixel electrode 191 form a driving TFT Qd together with a second semiconductor 154b. A channel of the driving TFT Qd is formed in the second semiconductor 154b between the second input electrode 173b and the second output electrode 175b.

In the present exemplary embodiment, only one switching TFT and one driving TFT are shown. However, at least one TFT and a plurality of wiring lines for driving the at least one TFT may be added. In this case, the deterioration of the OLED LD and the driving transistor Qd is prevented or compensated even though they are driven for a long time. As a result, it is possible to prevent deterioration of a lifetime of the OLED display.

The linear light emitter 390 including the pixel electrode 191, the organic light emitting member 370 and the common electrode 270 constitutes the OLED LD. In this case, the pixel electrode 191 may serve as an anode, and the common electrode 270 may serve as a cathode. Alternatively, the pixel electrode 191 may serve as a cathode, and the common electrode 270 may serve as an anode. Further, the storage electrode 127 and the driving voltage line 172 overlapping each other form the storage capacitor Cst.

When the first and second semiconductors 154a and 154b are made of polysilicon, the first semiconductor 154a includes an intrinsic region (not shown) facing the first control electrode 124a and extrinsic regions (not shown) positioned at both sides of the intrinsic region, and the second semiconductor 154b includes an intrinsic region (not shown) facing the second control electrode 124b and extrinsic regions (not shown) positioned at both sides of the intrinsic region. The extrinsic regions are electrically connected to the first and second input electrodes 173a and 173b and the first and second output electrodes 175a and 175b, respectively. The ohmic contacts 163a, 163b, 165a and 165b may be omitted in alternative exemplary embodiments.

Further, the first and second control electrodes 124a and 124b may be positioned on the first and second semiconductors 154a and 154b, respectively. Even in this case, the gate insulating layer 140 is positioned between the first and second semiconductors 154a and 154b and the first and second control electrodes 124a and 124b. Further, the data conductors 171, 172, 173b and 175b may be positioned on the gate insulating layer 140 and may be electrically connected to the first and second semiconductors 154a and 154b through contact holes (not shown) formed in the gate insulating layer 140. Alternatively, the data conductors 171, 172, 173b and 175b may be positioned underneath the first and second semiconductors 154a and 154b and may be brought into electrical contact with the first and second semiconductors 154a and 154b formed thereon.

According to exemplary embodiments of the present invention, when nano-sized OLEDs are used, it is possible to form fine pixels and thus to realize a high-resolution OLED display.

While the present invention has been described in connection with what is presently considered to be practical exemplary embodiments, it is to be understood that the present invention is not limited to the disclosed exemplary embodiments, but, on the contrary, is intended to cover various modifications and equivalent arrangements included within the spirit and scope of the appended claims.

## Claims

1. An OLED comprising:
a first electrode;
a second electrode facing the first electrode; and
a light emitting member interposed between the first electrode and the second electrode,
wherein the first electrode, the second electrode and the light emitting member form a linear light emitter having a coaxial structure.

2. The OLED of claim 1, wherein the linear light emitter has a diameter equal to or smaller than about 200 nm.

3. The OLED of claim 1, wherein the linear light emitter comprises:
a core including the second electrode;
a first shell surrounding the core and including the light emitting member; and
a second shell surrounding the first shell and including the first electrode.

4. The OLED of claim 1, wherein the linear light emitter comprises:
a first shell formed having a hollow therein and including the second electrode;
a second shell surrounding the first shell and including the light emitting member; and
a third shell surrounding the second shell and including the first electrode.

5. The OLED of claim 1, wherein the light emitting member comprises:
a light emitting layer including an organic semiconductor; and
at least one of a first auxiliary layer interposed between the light emitting layer and the first electrode and a second auxiliary layer interposed between the light emitting layer and the second electrode.

6. The OLED of claim 1, wherein at least one of the first electrode and the second electrode comprises a transparent material.

7. The OLED of claim 1, wherein the linear light emitter is a nanowire or a nanotube.

8. The OLED of claim 1, wherein the first electrode, the second electrode and light emitting member interposed therebetween are concentric.

9. A method of manufacturing an OLED comprising:
preparing a template having a first pore therein;
forming in the first pore a first tube-shaped electrode having a second pore whose diameter is smaller than that of the first pore;
forming in the second pore a tube-shaped light emitting member having a third pore whose diameter is smaller than that of the second pore; and
forming a second electrode in the third pore.

10. The method of manufacturing an OLED of claim 9, wherein, in the forming of the light emitting member, at least one layer is formed.

11. The method of manufacturing an OLED of claim 9, wherein the second electrode is formed in a tube shape or a rod shape.

12. The method of manufacturing an OLED of claim 9, wherein at least one of the forming of the first electrode, the forming of the light emitting member and the forming of the second electrode is performed by a vapor phase method.

13. The method of manufacturing an OLED of claim 12, wherein the vapor phase method includes vapor deposition.

14. The method of manufacturing an OLED of claim 12, wherein the vapor phase method includes vapor polymerization.

15. The method of manufacturing an OLED of claim 14, wherein the vapor polymerization comprises:
supplying gaseous monomers into at least one of the first, second and third pores; and
polymerizing the monomers.

16. The method of manufacturing an OLED of claim 15, wherein the polymerizing of the monomers is performed in a vacuum atmosphere.

17. The method of manufacturing an OLED of claim 15, wherein the polymerizing of the monomers is performed at a temperature of about 50° C to about 200° C.

18. The method of manufacturing an OLED of claim 15, further comprising:
introducing a polymerization initiator into at least one of the first, second and third pores before the supplying of the monomers.

19. The method of manufacturing an OLED of claim 18, wherein the polymerization initiator contains at least one of 2,2'-azobisisobutyronitrile (AIBN), benzoyl peroxide (BPO), cerium ammonium nitride (CAN) and ferric chloride (FeCl₃).

20. The method of manufacturing an OLED of claim 15, further comprising:
separating the OLED from the template after the polymerizing of the monomers.

21. The method of manufacturing an OLED of claim 20, wherein:
the template comprises aluminum oxide; and
the separating of the OLED is performed by etching the template.

22. The method of manufacturing an OLED of claim 21, wherein at least one of sodium hydroxide and hydrochloric acid is used for the etching.

23. An OLED display comprising:
a substrate; and
a plurality of linear light emitters formed on the substrate,
wherein each of the linear light emitters comprises a first electrode, a second electrode and a light emitting member interposed between the first electrode and the second electrode, which form a coaxial structure.

24. The OLED display of claim 23, wherein the linear light emitter is a nanowire or a nanotube.

25. The OLED display of claim 23, further comprising a TFT connected to the linear light emitter.

26. The OLED display of claim 23, wherein the first electrode, the second electrode and light emitting member interposed therebetween are concentric.

27. An OLED display comprising:
a substrate;
a first signal lines formed on the substrate;
a second signal lines intersecting the first signal line;
a first TFT connected to the first and second signal lines;
a second TFT connected to the first TFT; and
a linear light emitter connected to the second TFT,
wherein each of the linear light emitter comprises:
a first electrode connected to the second TFT;
a second electrode facing the first electrode; and
a light emitting member interposed between the first electrode and the second electrode,
wherein the first electrode, the light emitting member, and the second electrode form a coaxial structure.

28. The OLED display of claim 27, wherein the linear light emitter has a diameter equal to or smaller than about 200 nm.

29. The OLED display of claim 27, wherein the linear light emitter is a nanotube or a nanowire.

30. The OLED display of claim 27, wherein the first electrode, the second electrode and light emitting member interposed therebetween are concentric.
